# EUROPÄISCHE PATENTANMELDUNG

(11) **EP 0 540 497 A2**
(43) Veröffentlichungstag der Anmeldung: **05.05.1993**
(21) Anmeldenummer: 92890230.3
(22) Anmeldetag: 28.10.1992
(51) Int. Cl.: H05K 3/34

(54) **Verfahren zur Herstellung fester Lotbeschichtungen**

(30) Priorität: 29.10.1991 AT 2145/91
(71) Anmelder: Alcatel Austria Aktiengesellschaft, A-1210 Wien (AT)
(72) Erfinder: Thuernbeck, Johann, Mag. DIng. DDr., A-1210 Wien (AT)

(57) **Zusammenfassung**

Beim Auflöten von SMD-Bauteilen auf Leiterplatten ist es üblich, die erforderlichen Lötstellen mit Lot vorzubeschichten und die Bauteile durch exaktes Positionieren und Wiederaufschmelzen des Lotes zu befestigen. Um das Positionieren zu erleichtern und um eine höhere Genauigkeit zu erzielen, sollen die Lötstellen eine ebene Oberfläche aufweisen. Dies wird beim vorliegenden Verfahren dadurch gewährleistet, daß das Lot (2) mittels einer Matrize (1) auf die Lötpunkte (3) der Leiterplatte (4) aufgebracht wird. Die Oberflächenform der Vorbeschichtung (2) entspricht nach dem Umschmelzen und Abheben der Matrize (1) genau der Matrizenoberfläche (5).

## Beschreibung

Die Erfindung betrifft eine Vorrichtung und ein Verfahren zur Herstellung fester Lotbeschichtungen auf lötbaren Oberflächenbereichen eines Trägerteils, die zur Befestigung von Montageteilen, beispielsweise von oberflächenmontierten Bauelementen (SMD) durch Wiederaufschmelzlöten dienen, wobei eine Matrize auf den mit den lötbaren Oberflächenbereichen des Trägerteiles korrespondierenden Flächen mit Lot vorbeschichtet wird, diese vorbeschichtete Matrize auf dem Trägerteil so positioniert wird, daß die Lotteile auf den entsprechenden lötbaren Oberflächenbereichen aufliegen, beim darauffolgenden Lotumschmelzvorgang das Lot die lötbaren Oberflächenbereiche des Trägerteiles benetzt und nach dem Wiedererstarren des Lotes die Matrize vom Trägerteil abgenommen wird.

Für feste Lotbeschichtungen auf den Leiterplatten-Lötanschlußflächen für SMD-Bauelemente wird versucht, möglichst ebene Lotoberflächen zu erzielen, um die Bauteilpositionierungsgenauigkeit zu erhöhen. Dafür sind folgende Methoden bekannt:
- Selektive galvanische Lotabscheidung auf den Leiterplatten-Lötanschlußflächen bei Verwendung einer zusätzlichen Galvanoresistfolie, die die restliche Leiterplattenoberfläche abdeckt.
- Auf den von einer zusätzlichen, temporären Polymermaske nicht bedeckten Leiterplattenanschlußflächen wird mittels einer Lotbeschichtungsanlage flüssiges Lot aufgebracht und mit ebener Oberfläche zum Erstarren gebracht
- Auf die von einer zusätzlichen, temporären Polymermaske nicht bedeckten Leiterplattenanschlußflächen wird mittels Schablonendruck Lotpaste aufgebracht. Nach dem Aufschmelzen dieser Lotpaste wird die Lotoberfläche mit einer heißen Metallplatte bis zum Erstarren flachgedrückt.

Diese Verfahren haben den Nachteil, daß für jede einzelne Leiterplatte eine eigene Abdeckmaske benötigt wird. Diese ist sehr leicht verletzbar, da sie nach Beendigung des Verfahrens noch abwaschbar sein muß. Ein weiterer Nachteil besteht darin, daß bereits bestückte Leiterplatten mit diesen Verfahren nicht repariert werden können.

Aus der EP 0 352 432 A2 ist ein Verfahren bekannt, das zur Übertragung von Lotteilen eine Matrize verwendet, die aus einer mit einer leitenden Schicht überzogenen Basisschicht besteht, auf der wiederum eine Maskenschichte aufgetragen ist, die an den mit den lötbaren Oberflächenbereichen des Trägerteiles korrespondierenden Flächen entsprechende Ausnehmungen enthält. Durch Anlegen einer elektrischen Spannung an die Leiterschicht werden in diesen Ausnehmungen auf galvanischem Weg die benötigten Lotteile abgeschieden und anschließend durch einen Umschmelzvorgang auf den Trägerteil aufgebracht. Nachteilig ist dabei die aus drei Schichten bestehende Matrize und die sehr aufwendige galvanische Aufbringung des Lotes.

Es ist Aufgabe der Erfindung, ein Verfahren und eine Einrichtung zu finden, die eine einfache Raparaturmöglichkeit für bestückte Leiterplatten bietet und dabei die Nachteile der bekannten Einrichtungen und Verfahren vermeidet.

Die Erfindung löst diese Aufgabe dadurch, daß die Matrize aus einem monolithischen Material besteht. Sie ist dadurch auf einfache Weise herstellbar und kann ohne großen Aufwand beispielsweise mittels Siebdruck oder Schablonendruck mit Lotpaste beschichtet werden.

Nach einer Ausgestaltung der Erfindung ist die Matrize aus einem Glasplättchen in der Größe des zu lötenden Oberflächenteilbereiches ausgeführt und erleichtert den Positioniervorgang auf der Leiterplatte, da die Lötpunkte durch die Matrize hindurch erkennbar sind. Außerdem kann bei Verwendung einer solchen transparenten Matrize die Umschmelzwärme durch Strahlung (z. B. Laser, IR-Strahler) partiell dem Lot zugeführt werden.

In einer vorteilhaften Weiterbildung der Erfindung enthält die Matrize an den für die Vorbeschichtung vorgesehenen Flächenteilen ebene Ausnehmungen. Bei einer derartig geformten Matrize kann der Siebdruck entfallen und die Vorbeschichtung erfolgt durch einfaches Auffüllen der Vertiefungen mit Lot.

Eine weitere Ausgestaltung der Erfindung sieht vor, daß die Ausnehmungen durch Ätzung des monolithischen Materials hergestellt sind. Dadurch können in den Ausnehmungen feinste Strukturen hergestellt werden was wiederum einen hohen Miniaturisierungsgrad bei der Herstellung der Lötpunkte erlaubt.

Eine Ausgestaltung der Erfindung sieht vor, daß die Umschmelzwärme durch Heißluft der Matrize zugeführt wird und von der Matrize durch Konduktion auf das Lot übergeht. Das an sich bekannte Verfahren zur Aufheizung hat bei Verwendung einer erfindungsgemäßen Matrize den Vorteil, daß die thermische Belastung der Leiterplatte in Grenzen bleibt, da die Matrize den größten Teil der Wärme aufnimmt und an das Lot abgibt.

Bei Verwendung einer transparenten Matrize kann nach einer weiteren Ausgestaltung der Erfindung die Umschmelzwärme durch Strahlung ,beispielsweise mittels Laser oder Infrarotstrahler partiell dem Lot zugeführt werden. Bei diesem Vefahren werden möglichst nur die Löpunkte erhitzt, es bietet die geringste Wärmebelastung für die Leiterplatte und bei Reparaturarbeiten werden die bereits aufgelöteten Bauteile überhaupt nicht belastet.

Die Matrize kann dabei nach einer Weiterbildung der Erfindung mittels Schablonendruck mit Lot in pastöser Form vorbeschichtet werden. Dieses Verfahren ist besonders vorteilhaft bei der Herstellung von Lotbeschichtungen auf Teilflächen einer Leiterplatte, beispielsweise bei einer Reparatur von bestückten Leiterplatten.

Im folgenden wird die Erfindung anhand von lediglich einen Ausführungsweg darstellenden Zeichnungen näher erläutert. Es zeig Fig. 1 den Querschnitt durch die bereits mit Lot oder Lotpaste beschichtete Matrize und den Trägerkörper mit vom Lot benetzbaren Oberflächenbereichen, Fig. 2 den Querschnitt durch die auf dem Trägerkörper positionierte Matrize, Fig. 3 den Querschnitt durch Matrize und Trägerkörper nach dem Umschmelzen des Lotes und Fig. 4 den Querschnitt durch die abgehobene Matrize und den Trägerkörper, der mit einer Lotbeschichtung mit definierter Oberflächenform bedeckt ist.

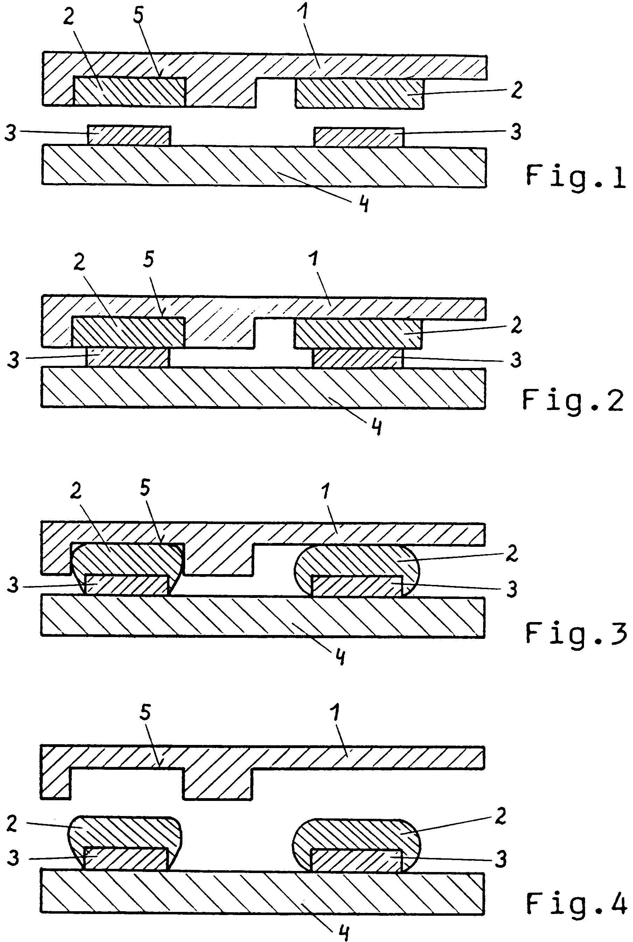

Der in Fig. 1 dargestellte Trägerkörper 4, beispielsweise eine Leiterplatte, weist an bestimmten Stellen mit Lot benetzbare Oberflächenbereiche 3 in Form von Lötpunkten auf den Leiterbahnen auf. Ziel des Verfahrens ist es, diese Stellen mit Lot 2 zu beschichten, um dort nach Bedarf SMD-Bauteile anzubringen. Dabei kann die Oberflächenform der Lotstellen durch Verwendung einer Matrize 1 vorgegeben werden. Die Matrize 1 wird mit Lot oder Lotpaste 2 zum Beispiel im Schablonendruck vorbeschichtet. Die Vorbeschichtung kann auch durch Auffüllen ebener Ausnehmungen 5 in der Matrize 1 mit Lotpaste 2 erfolgen. Im anschließenden Umschmelzverfahren wird die Matrize 1 auf der Leiterplatte 4 positioniert (Fig. 2) und das Lot bzw. die Lotpaste 2 bis über die Schmelztemperatur erhitzt (Fig. 3). Die Oberfläche der Leiterplatte 4 wird dabei an den vorgesehenen Lötpunkten 3 mit dem Lot 2 benetzt. Nach einem Abkühlvorgang wird die Matrize 1 abgehoben, das Lot 2 verbleibt auf der Leiterplatte 4 mit einer vorgegebenen Oberflächenform (Fig.4). Nun können Montageteile, beispielsweise SMD-Bauelemente durch Wiederaufschmelzen des Lotes 2 auf die Leiterplatte, beispielsweise auf die Leiterbahnen 3 aufgebracht werden, wobei deren Positionierung durch die ebene Oberflächenform der Lötpunkte 2 erleichtert wird.

## Patentansprüche

1. Vorrichtung zur Herstellung fester Lotbeschichtungen auf lötbaren Oberflächenbereichen eines Trägerteils, die zur Befestigung von Montageteilen, beispielsweise von oberflächenmontierten Bauelementen (SMD) durch Wiederaufschmelzlöten dienen, wobei eine Matrize (1) auf den mit den lötbaren Oberflächenbereichen (3) des Trägerteiles (4) korrespondierenden Flächen (5) mit Lot (2) vorbeschichtet wird, diese vorbeschichtete Matrize (1) auf dem Trägerteil (4) so positioniert wird, daß die Lotteile (2) auf den entsprechenden lötbaren Oberflächenbereichen (3) aufliegen, beim darauffolgenden Lotumschmelzvorgang das Lot (2) die lötbaren Oberflächenbereiche (3) des Trägerteiles (4) benetzt und nach dem Wiedererstarren des Lotes (2) die Matrize (1) vom Trägerteil (4) abgenommen wird, **dadurch gekennzeichnet,**daß die Matrize (1) aus einem monolithischen Material besteht.

2. Vorrichtung nach Anspruch 1, **dadurch gekennzeichnet,** daß die Matrize (1) aus einem Glasplättchen in der Größe des zu lötenden Oberflächenteilbereiches ausgeführt ist.

3. Vorrichtung nach Anspruch 1 oder 2, **dadurch gekennzeichnet,** daß die Matrize (1) an den mit den lötbaren Oberflächenbereichen (3) des Trägerteiles (4) korrespondierenden Flächen (5) ebene Ausnehmungen enthält.

4. Vorrichtung nach Anspruch 3, **dadurch gekennzeichnet**, daß die Ausnehmungen (5) durch Ätzung des monolithischen Materials hergestellt sind.

5. Verfahren zur Herstellung fester Lotbeschichtungen auf lötbaren Oberflächenbereichen eines Trägerteils, die zur Befestigung von Montageteilen, beispielsweise von oberflächenmontierten Bauelementen (SMD) durch Wiederaufschmelzlöten dienen, wobei eine Matrize (1) auf den mit den lötbaren Oberflächenbereichen (3) des Trägerteiles (4) korrespondierenden Flächen (5) mit Lot (2) vorbeschichtet wird, diese vorbeschichtete Matrize (1) auf dem Trägerteil (4) so positioniert wird, daß die Lotteile (2) auf den entsprechenden lötbaren Oberflächenbereichen (3) aufliegen, beim darauffolgenden Lotumschmelzvorgang das Lot (2) die lötbaren Oberflächenbereiche (3) des Trägerteiles (4) benetzt und nach dem Wiedererstarren des Lotes (2) die Matrize (1) vom Trägerteil (4) abgenommen wird, **dadurch gekennzeichnet,**daß die Umschmelzwärme durch Heißluft der Matrize (1) zugeführt wird und von der Matrize (1) durch Konduktion auf das Lot (2) übergeht.

6. Verfahren zur Herstellung fester Lotbeschichtungen auf lötbaren Oberflächenbereichen eines Trägerteils, die zur Befestigung von Montageteilen, beispielsweise von oberflächenmontierten Bauelementen (SMD) durch Wiederaufschmelzlöten dienen, wobei eine Matrize (1) auf den mit den lötbaren Oberflächenbereichen (3) des Trägerteiles (4) korrespondierenden Flächen (5) mit Lot (2) vorbeschichtet wird, diese vorbeschichtete Matrize (1) auf dem Trägerteil (4) so positioniert wird, daß die Lotteile (2) auf den entsprechenden lötbaren Oberflächenbereichen (3) aufliegen, beim darauffolgenden Lotumschmelzvorgang das Lot (2) die lötbaren Oberflächenbereiche (3) des Trägerteiles (4) benetzt und nach dem Wiedererstarren des Lotes (2) die Matrize (1) vom Trägerteil (4) abgenommen wird, **dadurch gekennzeichnet,** daß die Umschmelzwärme durch Strahlung, beispielsweise mittels Laser oder Infrarotstrahler, partiell dem Lot zugeführt wird.

7. Verfahren nach Anspruch 5 oder 6, **dadurch gekennzeichnet,** daß die Matrize (1) mittels Schablonendruck mit Lot (2) in pastöser Form vorbeschichtet wird.
